# EUROPEAN PATENT APPLICATION

(11) **EP 4 844 765 A1**
(43) Date of publication of application: **25.11.2026**
(21) Application number: 25177508.6
(22) Date of filing: 20.05.2025
(51) Int. Cl.: G11C 17/16, G11C 17/18

(54) **IMPROVING EFFICIENCY OF USE OF ONE-TIME PROGRAMMABLE MEMORY IN AN INTEGRATED DEVICE**

(71) Applicant: Murata Manufacturing Co., Ltd., Nagaokakyo-shi, Kyoto 617-8555 (JP)
(72) Inventor: MÄENPÄÄ, Teppo, 00760 Helsinki (FI)
(74) Representative: Boco IP Oy Ab

(57) **Abstract**

The disclosure relates to an OTP memory, and an integrated device comprising the OTP memory, as well as to methods for writing data in and reading data from the OTP memory. The OTP memory is divided into a linear portion and a log portion. Initial data values are stored in the linear portion and any updated data value replacing one of the initial data values are stored in the log portion. All OTP memory contents are read to initialize and control operation of the integrated device.

## Description

### FIELD OF THE DISCLOSURE

The present disclosure relates to digital memory, and in particular to a one-time programmable, OTP, memory in integrated devices, such as MEMS devices. The present disclosure further concerns methods to write and read data in the OTP memory of an integrated device.

### BACKGROUND OF THE DISCLOSURE

The term OTP memory refers to a non-volatile memory, which can only be programmed once. OTP memory is basically designed for a single instance of programming, creating a permanent configuration that is valuable in settings where data integrity and security are crucial. Distinct characteristics of OTP memory cater to specific applications. Once data is written, it cannot be changed or erased. OTP memory is useful in integrated devices where the data stored needs to remain consistent. Data is retained without power, once written data cannot be altered or deleted. OTP memory is also simple and cheap than other memory types. In general, OTP memory is most typically applied to store critical instructions, storing unique product information and permanent storage for integrated device firmware.

Micro-electromechanical systems, MEMS, devices are systems that combine electronics and moving parts in microscopic size. MEMS devices are one type of integrated devices. MEMS devices typically comprise at least one MEMS portion comprising mechanical elements interacting with the physical surroundings, and electronic circuitry for implementing driving and/or detection of motion and/or position of the mechanical elements. The MEMS device comprises one or more transducers configured to convert between mechanical and electrical variables. Transducers are typically ohmic or capacitive. Typical MEMS device comprises an application specific integrated circuit (ASIC) for processing input and/or output signals. In a typical MEMS device implementation, an ASIC chip is put in a same component package with one or more separate MEMS chips. In a sensor-type integrated device, such as a MEMS sensor device, the ASIC portion is configured to convert at least one physical characteristic of a mechanical element in the MEMS portion into at least one digital signal. The ASIC portion may also be configured to control operation of the MEMS portion. Controlling operation of the MEMS portion is needed for example, when one or more mechanical elements of the MEMS portion are driven into a motion. Examples of MEMS sensors are for example gyroscopes, accelerometers, and pressure sensors, and also so called Inertial Measurements Units, IMUs, which typically are a combination of different types of MEMS sensing elements. The principle of gyroscope can also be applied in a gyrocompass. At least one micromechanical element in the MEMS portion may be driven into a motion even if the micromechanical part is not itself used for sensing. For example, MEMS micromirrors are driven into a motion and used for directing light beams in various types of scanning devices, for example in laser scanners, LIDARS (light-detecting and ranging sensors), but also in augmented or virtual reality glasses. The ASIC may play a role in a MEMS device for example in signal amplification, filtering, digitization (analog-to-digital conversion), temperature compensation and sensor fusion. The functional portion of a MEMS device is a micromechanical portion, which typically has at least some electrical characteristics, such as transducers for performing conversions between various mechanical and electrical quantities in either direction.

There are lots of examples of other integrated devices having a functional portion (i.e. at least one functional element) and an ASIC. Various sensors use sensing elements not based on MEMS technology. For example, thermistors and resistance temperature detectors (RTDs) may comprise an ASIC that performs for example linearization, analog-to-digital conversion and/or produce digital output. Gas and air quality sensors comprise a functional element such as metal oxide or some other electrochemical sensing element, and ASIC performs signal conditioning, calibration, digital interface and/or algorithm processing. Humidity sensors may be based on a capacitive or resistive polymer film as sensing element, and the ASIC is used for signal conditioning, temperature compensation, calibration and/or digital output.

Optical sensors may use photodiodes as sensing element, and ASIC may perform signal amplification, noise filtering, digitization and even more sophisticated functions such as gesture recognition algorithms. Image sensors have an array of photodiodes as a sensing element, and the ASIC performs tasks such as readout, analog-to-digital conversion, noise reduction, auto white balancing and image processing.

In this disclosure, we will refer to any applicable devices as integrated devices. An integrated device is any applicable type of sensor device and/or a MEMS device. The integrated device comprises at least one functional portion (i.e. at least functional element, such as sensing element) and an ASIC. The functional portion of the integrated device and the ASIC are packaged in a single component package. The ASIC of the integrated device uses an OTP type memory for permanently storing data values for enabling desired operation of the integrated device.

Typically, memories as individual chips are available in sizes having 2^n bytes, where n is a positive integer and ^ denotes exponentiation operation. Even when embedded in an ASIC, the OTP memory portion is typically implemented using a predesigned OTP memory circuitry block, which are made available in predetermined sizes having 2^n bytes. However, memory capacity need of the integrated device does not follow any 2^n byte rule. There are several pieces of data values that need to be determined and stored. However, a great majority of these data values is written just once and never changed afterwards. On the other hand, a small portion of data values may need to be changed from their initial data values and therefore rewritten several times.

The following explanation uses a simplified representation of the actual OTP memory 100. Some commonly applied pieces of data such as parity bits are not shown, because these are not needed to understand features affected by embodiments of the invention.

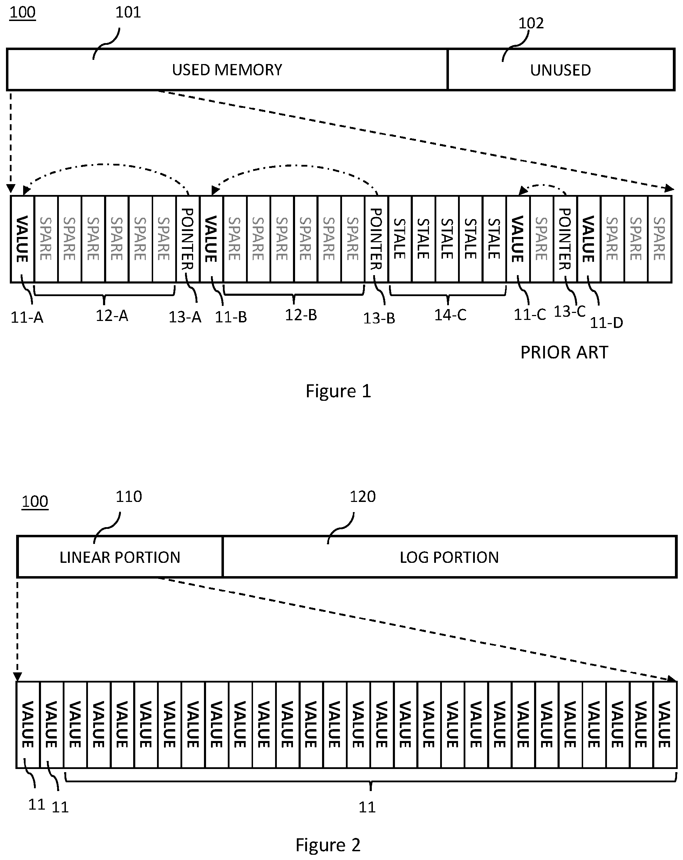

Figure 1 illustrates a typical arrangement of use of OTP memory 100 in an integrated device. A part of the OTP memory 100 referred herein as used memory 101 is used for storing data values, but typically a there is also an unused portion 102, simply because it is not needed, but the next smaller available memory in the 2^n byte rule -based series would be too small to cover all memory needs of the integrated device.

The lower part of figure 1 illustrates a portion of contents of the used memory 101. In this example, eight OTP memory blocks are arranged as a cluster, which is reserved for storing an initial data value 11, 6 spare blocks 12 and a pointer 13. Each cluster of eight OTP memory blocks may be considered as a virtual multiple-time programmable (MTP) memory, with a limited number of possibilities of "rewriting" each data value by replacing the previously stored value with an updated value written in the next available spare OTP memory block. The number of OTP memory blocks in the virtual MTP memory is a design variable. This exemplary structure enables each data value to be rewritten six times, while the respective pointer 13 determines, which one of these OTP memory blocks in the cluster is currently used and includes the valid data value. In this example, data values 11-A, 11-B and 11-D haven't been updated since they were first rewritten, and thus no spare OTP memory blocks in these clusters have been used. Pointers 13-A and 13-B point to the respective first OTP memory block in the cluster. Data value 11-C has been updated five times already, while the pointer 13-C identifies in which OTP memory block the current data value 11-C is stored. Previous, stale data values 14 remain stored in the respective OTP memory blocks, which cannot be rewritten due to the permanent characteristics of the OTP memory 100. Number of OTP memory blocks reserved for each data value is a design parameter. This illustration shows a problem with the traditional OTP usage, when spare OTP memory blocks 12 are reserved for each data value individually. Only a fraction of the reserved OTP memory area is used, while most OTP memory blocks are either unused spare OTP memory blocks 12 or used stale data value 14.

The unused portion 102 can be approximated as wasted memory space.

A problem in integrated devices, such as MEMS devices, is that any excess memory increases size and cost of the integrated device.

Document US 11,854,588 B2 discloses a multiple-time programmable, MTP, memory made up of virtual MTP memory blocks made of a plurality of OTP memory modules as known in the art.

### BRIEF DESCRIPTION OF THE DISCLOSURE

An object of the present disclosure is to provide a method to use OTP memory more efficiently, without wasting OTP memory blocks and memory chip area.

The object of the disclosure is achieved by an OTP memory, by methods to write the OTP memory, and by methods to read the OTP memory which are characterized by what is stated in the independent claims. The OTP memory of the disclosure is beneficially used in an integrated device, such as a MEMS device. Some embodiments of the disclosure are disclosed in the dependent claims.

The disclosure is based on the idea of storing initial data values in a linear portion of the OTP memory and storing any updated data values in a log portion, wherein the entire portion of the OTP memory that is not part of the linear portion is used for the log portion.

According to an aspect of the disclosure, a one-time programmable, OTP, memory configured to provide functionalities of a multiple-time programmable, MTP, memory is provided. The OTP memory comprises a linear portion configured to store a plurality of initial data values, and a log portion configured to store at least one address-data value pair. Each address-data value pair represents an updated data value of one of the plurality of initial data values that has been stored at a position of the linear portion determined by the address.

According to some embodiments, the log portion further comprises at least one error-detecting code, such as a cyclic redundancy check, CRC, code, stored after one or more address-data value pairs.

According to some embodiments, the OTP memory is configured to store data using unaligned access, wherein size of applied structs of data types stored in the OTP memory is independent OTP memory block size and wherein a start of a struct is independent of OTP memory block limits.

According to some embodiments, the OTP memory applies aligned access, and boundaries of initial data values, address-data value pairs and error-detecting code align with boundaries of OTP memory blocks, or the OTP memory applies unaligned access, wherein boundaries of initial data values, address-data value pairs and error-detecting code are not necessarily aligned with boundaries of OTP memory blocks.

According to an aspect of the disclosure, an integrated device comprising a functional portion and an application-specific integrated circuit, ASIC, comprising the OTP memory according to the above aspect and optionally any one of the above embodiments is provided. The OTP memory comprises data values for operating the integrated device.

According to an aspect of the disclosure, microelectromechanical system, MEMS, device comprising a MEMS portion and an application-specific integrated circuit, ASIC, comprising the OTP memory according to one the above aspects and optionally one of the embodiments is provided. The OTP memory comprises data values for operating the MEMS device.

According to an aspect of the disclosure, a method for writing data values in a one-time programmable, OTP, memory is provided. The OTP memory comprises a linear portion configured to store a plurality of initial data values, and a log portion configured to store updated data values. The method comprises obtaining one or more data values, and for each data value: i) obtaining an address of the data value, wherein the address indicates a position in the linear portion; ii) reading an initial data value from the position of the linear portion indicated by the address, and using the initial data value as a current data value. If the log portion comprises data, the method further comprises reading the entire log portion to determine, whether the log portion comprises one or more address-data value pairs indicating updated data values for the respective initial data value in the linear portion, the address referring to the position of the respective initial data value, and if the log portion comprises at least one address-data value pair with an updated data value, the method comprises using the respective data value read from the last respective address-data value pair as the current data value. The method further comprises comparing the obtained data value with the current data value, and if the obtained data value is different than the current data value, writing a new address-data value in the log portion. The address is the obtained address indicating position of the respective initial data value in the linear portion and the data value is the obtained data value. After all obtained data values have been processed, the method comprises adding an error-detecting code to the log portion.

According to some embodiments, the write operation further comprises, if, upon trying to read the initial data value from the linear portion, it is detected that the position in the linear portion indicated by the obtained address does not have any initial data value stored therein, storing the obtained data value to the position of the linear portion indicated by the obtained address, and after storing the obtained data value in the linear portion, proceeding to obtaining another data value, if available.

According to some embodiments, the OTP memory is comprised in an ASIC of an integrated device, and the integrated device further comprises a functional portion, and the OTP memory is used for storing data values for operating the integrated device. Then, the method comprises: performing a calibration of the integrated device, obtaining one or more data values based on the calibration, and writing said one or more data values into the OTP memory.

According to some embodiments, the method further comprises reading all data values stored linear portion, and applying error correction therein, if a corrected or uncorrectable error is detected in a data value read from the linear portion, marking respective data value as suspicious, reading all address-data value pairs stored in the log portion, and, when available, replacing data values read from the linear portion with data values read from the log portion, and if a corrected or uncorrectable error is detected in a data value read from the log portion, marking respective data value as suspicious, and if a data value is read correctly from the log portion that replaces a data value previously marked as suspicious, removing the marking from the data value as suspicious. After all data values have been read, the method comprises checking whether any data values marked as suspicious remain, and if so, rewriting address-data value pairs in the log portion for replacing all remaining data values marked as suspicious. After all data values that were previously marked as suspicious have been rewritten in in the log portion as address-data value pairs, the method comprises writing an error-detecting code in the log portion.

According to an aspect of the disclosure, a method for reading data values stored in a one-time programmable, OTP, memory is provided. The OTP memory comprises a linear portion and a log portion. The method comprises i) reading initial data values from the linear portion, and storing the initial data values in a working memory, ii) obtaining an entry from the log portion, iii) determining, whether the entry indicates presence of an error-detecting code or an address-data value pair, iv) if the entry indicates presence of an address-data value pair, reading the address-data value pair, the address referring to the position of the respective initial data value, and the data value replacing the respective initial data value and any previously stored updated data value of the respective initial data value in the working memory, and v) if the entry is an error-detecting code, noting the error-detecting code, vi) repeating steps ii) to v) until it is determined that there is no further entry in the log portion, and vii) upon determining, that there is no further entry in the log portion, performing an error detection using the last read error-detecting code.

According to some embodiments, presence of an address-data value pair is determined by detecting that the read entry comprises a valid address.

According to some embodiments, differential coding is applied. In such case, step vi) comprises reading at least one physical memory cell pair after the previously read entry in unipolar mode, and based on the read at least one physical memory cell pair, determining that there is no further entry in the log portion based on detecting that all or a significant majority of the physical memory cells of the at least one physical memory cell pair read in unipolar mode are unprogrammed, and/or determining that the log portion comprises further entries based on detecting that approximately half of physical memory cells in the at least one physical memory cell pair read in unipolar more appear to be programmed.

According to some embodiments, aligned access is applied, and boundaries of initial data values, address-data value pairs and error-detecting code are aligned with boundaries of OTP memory blocks.

According to some embodiments, unaligned access is applied, and boundaries of initial data values, address-data value pairs and error-detecting code are not always aligned with boundaries of OTP memory blocks.

According to some embodiments, when unaligned access is applied, when reading data from the log portion comprises: assuming that the size of the entry is equal to a predefined minimum, a) reading an entry from the log portion, and i. applying error correction on the entry, and if the error correction passes without need to correct any errors and the size of the entry matches the assumed size, determining that reading of the entry was successful. If reading of the entry in step i. is not determined to be successful, the method comprises increasing the size of the entry by one and repeating step a) until either i. is successful, or until the size of the entry reaches a predefined maximum. If the size of the entry reaches the predefined maximum without the reading of the entry being successful, the method returns to assuming that the size of the entry is equal to the predefined minimum, and then the method comprises b) reading an entry from the log portion, and ii. applying error correction on the entry, and if the error correction is performed successfully, and size of the entry matches the assumed size after the error correction was applied, determining that reading of the entry was successful. If reading of the entry in step ii. is not determined to be successful, the method comprises increasing the size of the entry by one and repeating step b) until step ii. is determined to be successful, or until the size of the entry reaches a predefined maximum. If the size of the entry reaches the predefined maximum, and reading of the entry was not determined to be successful, the method comprises deeming reading of the entry failed and optionally rising an error flag.

An advantage of the OTP memory and the read and write methods of the disclosure is that efficiency of use of OTP memory is improved, which enables reducing size of the OTP memory, and/or increasing capability of rewriting (updating) any data values that require multiple updates. No OTP memory blocks are reserved as spare for enabling rewriting data values that are never updated. No knowledge is required in advance on which individual data values may need to be updated. Omission of addresses from the linear portion further enables enhancing utilization or memory area. Omission of addresses from the linear portion is justified by the need to have any and all calibration and configuration data written at least once. The optimized OTP memory usage enables decreasing size and cost of ASIC circuitry and thus size and cost of integrated devices, such as MEMS devices.

### BRIEF DESCRIPTION OF THE DRAWINGS

In the following the disclosure will be described in greater detail by means of preferred embodiments with reference to the accompanying drawings, in which:
Figure 1 illustrates an OTP memory and a part of contents of a used portion of the OTP memory as known in the prior art.
Figure 2 illustrates an OTP memory according to some embodiments, and a linear portion of the OTP memory.
Figure 3 illustrates an OTP memory and contents of a portion of the log portion 120 according to some embodiments.
Figure 4 illustrates an OTP memory and contents of a portion of the log portion 120 according to some embodiments.
Figure 5A and 5B illustrate error correction code in the linear portion.
Figure 5C illustrates error correction code in the log portion.
Figure 6 illustrates a simplified process of writing data in the linear portion.
Figure 7 illustrates a simplified process of determining and writing initial and updated data values.
Figure 8 illustrates an exemplary process of writing initial and updated data values
Figure 9 illustrates steps of rewriting updated data values.
Figure 10 illustrates steps of reading of data values according to some embodiments.
Figure 11 illustrates steps of reading of data values according to some embodiments

### DETAILED DESCRIPTION OF THE DISCLOSURE

The present disclosure relates to digital memories, and in particular to a one-time programmable, OTP, memories. The disclosure takes advantage of characteristics of memory needs of a complex integrated device, such as a MEMS device, but the solution is also applicable to any other integrated devices or systems with like characteristics, where data values for operation of the integrated device need to be stored permanently. The disclosed methods of writing and reading data in OTP memory improves efficiency of OTP memory usage at least when used for permanently storing data values such as unique device identifiers, device quality group information, calibration parameters, algorithm descriptions, self-test parameters, self-test threshold values and/or correction multiplier values. The present disclosure further concerns methods for storing updated data in the OTP memory and methods for reading data from the OTP memory.

Modern, sophisticated manufacturing processes can produce integrated devices, including but not limited to functional portions thereof, with high accuracy and small tolerances. However, it is not possible in practice to eliminate all variations in manufacturing processes, but integrated devices typically need to be some calibration before their operation fulfils required quality and accuracy constraints. Calibration of the integrated device is usually performed by the manufacturer, before the integrated device is shipped to a customer. Calibration may be repeated for example in different temperatures, and subsequent calibration steps may arise a need to update some of the initial data values. A calibration process may be needed for any type of sensor devices (sensors), independent on whether it has moving parts like a MEMS device or not. Any functionality of the integrated device beyond mere unique identifier thereof may benefit from obtaining applicable data values (parameters) that can be obtained through calibration.

To ensure availability of calibration data values at any time, calibration data values are stored permanently in an OTP memory that is part of the ASIC portion. This enables for example resetting the integrated device in case of some operation error is detected. When initiating or restarting operation of the integrated device, calibration data values are read from the OTP memory into a working memory. The working memory is preferably a distributed memory, but may also be a random-access memory, RAM. The person skilled in the art recognizes various sub-categories of these known memory types.

Other types of data may be stored in the OTP memory of the integrated device, which are permanent in nature. Such data is for example a unique identification of the integrated device, such as a serial number. Identification of an individual integrated device may be needed during the manufacturing process so that each integrated device can be calibrated individually. This is because due to various tolerances and error sources, each integrated device may have slightly different physical, mechanical and/or electrical characteristics, which affect some of the calibration data values. Some safety-critical applications may also require maintaining, by the manufacturing, manufacturing and/or calibration data of the integrated device even over its lifetime. Data values stored in the OPT memory may thus also be retained by the manufacturer, and these data values may enable cross-checking data values stored in any individual integrated device.

In addition, or as alternative to a unique identifier, information such as a device quality group may be permanently stored in the OTP memory. The device quality group refers to the idea of making available more than one version of the basically same product that have different quality. This way, it is possible to sell higher quality products with higher price, while ensuring the high quality also requires more careful testing and/or calibration process, which increases production cost. For example, an integrated device in a high-end device quality group is calibrated more carefully and/or tested more before delivery to a client, to ensure that its operation, i.e. sensor readings, fulfil very strict requirements, whereas a bit less effort is put to test and/or calibrate an integrated device in a lower-end device quality group. Thus, operation accuracy of the lower-end device quality group needs to fulfil less strict accuracy requirements. Device quality group may also be determined during testing and/or calibration; initially, all integrated devices are treated equal in the testing and/or calibration, and they are put in appropriate device quality group based on level of accuracy of operation after calibration. Achievable accuracy of operation of each individual integrated device may depend for example on manufacturing tolerances, material defects etc., which may affect any physical characteristics of the integrated device.

In drawings and in the following description, contents of the OTP memory 100 are illustrated as a simple memory block array. The same principle of OTP memory utilization is applicable also to more complex OTP memory architectures.

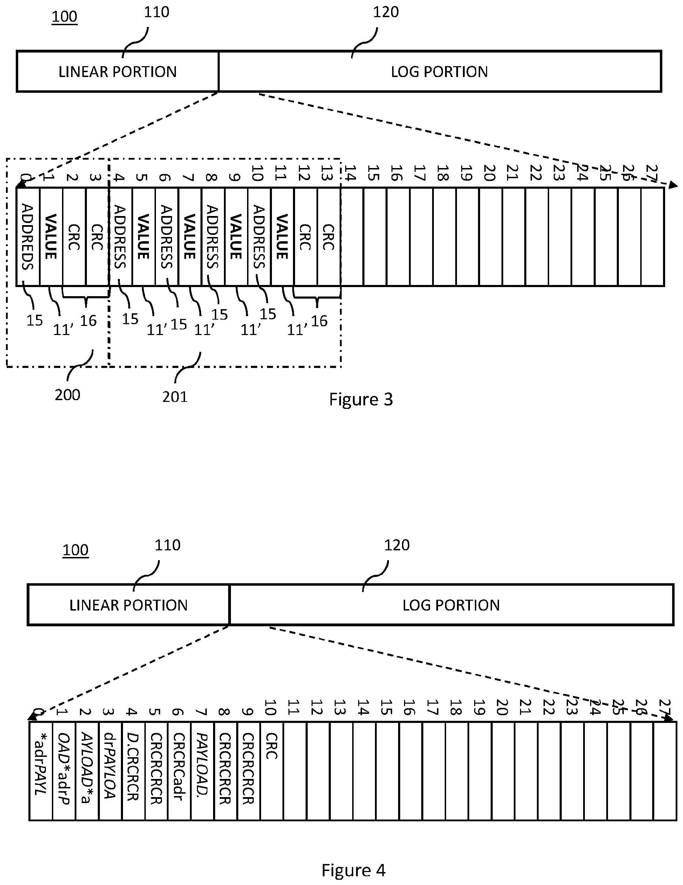

Figures 2 and 3 illustrate basics of the discovery for the efficient use of OTP memory according to some embodiments.

As shown in figures 2 and 3, the underlying arrangement of the OTP memory 100 is based on dividing the OTP memory 100 into two portions: a linear portion 110 and a log portion 120.

The linear portion 110 is used for storing all initial data values 11, in other words the first-written data values. This is illustrated in the Figure 2, where the lower part of the figure illustrates contents of the linear portion. All space of the linear portion 110 is in use, so that the size of the linear portion essentially matches with the amount of payload data needed. It should be noted that Figure 2 is a simplified illustration, omitting various commonly applied pieces of data such as parity bits, and/or other error correction code (ECC), log parsing hints etc. for ensuring correctness of the stored data values 11 and/or enabling correction of minor errors in the data values 11 when read. Such additional pieces of data are preferably stored in the linear portion 110 in association with the initial data values 11 but are not necessary to understand the basic principles of the disclosure.

In a simple case, all data is written in the linear portion just one write process. In many practical cases, data values may be written in the linear portion 110 in more than one write round.

For example, a serial number of an integrated device is typically stored at an early phase so that each individual integrated device can be identified during later steps of the manufacturing and/or calibration process. Initial data values obtained during steps of a calibration process are also stored in the linear portion 110, and different parameters' data values may be stored even by totally different pieces of equipment. Typically, initial data values of parameters can be predetermined with high accuracy during design of the integrated device, but small variations in physical, mechanical and/or electrical characteristics of individual integrated devices arise a need for updating some data values to ensure that when in operation, operation and/or output data from the integrated device fulfils all accuracy requirements set forth. This disclosure uses term CRC (Cyclic Redundancy Check) and CRC code for simplicity in the figures and description. However, any known type of error-detecting codes may be applied instead, such as checksum. As known in the art, error-detecting codes comprise redundant data attached to a digital message, composed at the formation of said digital message. These error-detecting codes are typically digested at the moment of message reception, to differentiate intact messages from corrupted one. Cyclic Redundancy Checks (CRC) are a family of widely used error-detecting codes. In this invention disclosure, the exemplary CRC may be replaced by any known error-detecting code, capable of detecting multi-bit errors at large detecting probability, to differentiate these error-detecting codes from error correcting codes, which aim to correct isolated errors, at the expense of error discovery power, also mentioned here.

There are two distinct reasons to write the error-detecting code in the OTP memory: 1) Allow the chip itself to know whether a data readout has been successful, and 2) cross-referencing data correctness during manufacturing process. There may be cases where neither justification applies; one example case would be a partial write to the linear region comprising for example only identity information. The on-chip identity information such as a serial number only functions as a guarantee of an absence of handling errors. In those cases, writing the CRC or any other applicable error correcting code may be omitted. Figure 3 illustrates the OTP memory 100 and contents of the log portion 120 according to some embodiments.

In the figure 3, the exemplary data stored in the log portion comprises address-data value pairs, plus a cyclic redundancy check, CRC, code at the end of each rewrite round.

The term rewrite refers to an operation of writing updated data values in the log portion. Updated data values replace initial data values 11 in the linear portion 110, or previous updated data values 11' in the log portion 120.

The term address refers to information that enables finding location in the OTP memory where a data is to be/has been written. The address can refer to the linear portion or to the log portion. Typically, addresses of an ASIC OTP memory are not packed, i.e. there may be invalid numeric values of address between valid ones; in this statement, an invalid address does not refer to any position in the OTP memory that would be able to receive and store data. On the other hand, in the linear portion 110, each piece of data is preferably adjacent to another; in other words, the data are tightly packed. In context of the log portion 120, 'address' as a data struct element may also refer to a data ordinal of a memory location of a data value in the linear portion 110, thus providing a benefit of a smaller number of bits needed in the data ordinal compared to a bus address. In this context, a data ordinal is also referred in short as an ordinal. This can be implemented for example by using a hardcoded ordinal-to-bus-address converter in the reader of the tightly packed linear region: Reducing the number of bits in the address field allows more tight packing of data in the log portion and is therefore useful especially in the context of unaligned data. On the other hand, especially in connection with unaligned access, address may refer to the ordinal corresponding to a storage location of a data value even if the ordinal is not necessarily written in the OTP memory.

The number of address-data value pairs in each rewrite round equals the number of data values changed from their previous values, which may be the initial data value 11, or an updated data value 11' that was updated in one or more previous rewrites. Note that this is simplified graph; for example, there are typically some guard bits to identify forthcoming data as either an additional address 15 or an error-detecting code 16, there may be guard bits between the updated data value 11' and the start of the error-detecting code 16, there may be parity bits and/or error correction code (ECC) stored in each rewrite, and so on. Such additional data is omitted, because it is not necessary for explaining the basic principle of the disclosure. The address of the address-data value pair indicates address of the initial data value in the linear portion, even if there would be a previous updated data value for the respective piece of data in the log portion.

In a typical OTP memory implementation, there are less address bits than data value bits. In such case, since all OTP memory blocks usually have equal size, guard bits are preferably be tied to the address field, which is more likely to have room for some extra bits.

If data values are written in the linear portion 110 in more than one write round. In such case, the linear portion 110 is preferably read before further data is written therein, the log portion 120 may be used for writing a cyclic redundancy check, CRC, code or other error-detecting code that enables verifying that all data that was previously stored in and later read from the linear portion was correctly read. In such case, the log portion 120 may start with an error-detecting code 16, such as CRC.

Figure 3 illustrates the log portion 120 after two rewrites 200, 201, marked with dotted lines. OTP memory blocks in the log portion 120 are numbered for clarity. Number of OTP memory blocks affected by any rewrite round depends on the selected coding scheme as well as number of data values that need to be updated.

In a first rewrite 200, OTP memory blocks 0 to 3 were occupied for enabling storing one updated data value 11'. The log portion stored in the first rewrite 200 comprises the updated data value 11', an address 15, which determines, which one of the initial data values 11 has been updated in the rewrite and is thus replaced by the updated data value 11'. The first rewrite further comprises error-detecting code 16, which in this non-limiting example is a CRC that occupies two OTP memory blocks.

In the second rewrite 201, four data values were updated. These updates may concern data values were not updated in any preceding rewrite, such as the first rewrite 200, and/or data values that were changed since the any one of the previous rewrites, which in this simplified example is represented by the first rewrite 200. The exemplary second rewrite 201 occupies OTP memory blocks 4 to 13. The four data values rewritten in the second rewrite 201 may or may not comprise a new data value for the data value that was rewritten in the first rewrite 200.

The order of different data types in the log area follows the depicted scheme. The address 15 is preferably written in the log portion 120 before the respective updated data value 11'. In other words, updated data is provided in the log portion in form of address-value pairs. This provides an easy and robust method for detecting end of rewritten data in the log portion 120. When the end of the rewritten portion is reached, the read process reaches and reads an empty OTP memory block, in this example the stale data value 14. After reading an error-detecting code 16, the read method tries to read an address. By determining that an address that corresponds to an unwritten OTP memory block is invalid, the read method immediately recognizes that there is no more valid data values or addresses available in the log portion, and thus it is determined that all available data has been read from the log portion 120.

In the first rewrite 200 illustrated in the Figure 3, the number of OTP memory blocks needed was four times the amount of rewritten data. However, the more pieces of data values are updated in a rewrite, the more efficient the format becomes, eventually approaching the ratio of (sum of data value and address sizes / size of data value alone), because the CRC code is only needed once per rewrite. In the second rewrite 201, the number of OTP memory blocks needed to update four data values is ten, thus 2.5 times the amount of rewritten data values, in this case four updated data values.

A real-life integrated device may have for example 300 data values in its linear portion 110, each occupying one OTP memory block. If the address occupies one OTP memory block and CRC code occupies two, rewriting updated valued for all 300 initial data values would occupy 300+300+2 OTP memory blocks.

In comparison to the prior art solution, in which number of spare OTP memory blocks 12 for any individual data value 11 sets a hard limit to number of available rewriting rounds for this data value 11, the only factor limiting number of rewriting rounds in the disclosed solution is size of the OTP memory itself, or, more precisely, the size of the log portion 120, which is defined by OTP memory size minus the size of the linear portion.

Due to the characteristics and use of data values in the OTP memory 100 of an integrated device, such as a MEMS device, need for rewriting data values is not evenly distributed, but the distribution is spiky: some data values are more likely to be updated than others. However, is not possible to predict reliably, which data values will need more updates. In the traditional virtual MTP memory solution as disclosed in the Figure 1, this leads to a need to reserve spare OTP memory blocks to many data values that are never updated or are updated perhaps only once. The disclosed, log-based data value update scheme efficiently avoids reservation of any obsolete spare OTP memory blocks.

Figure 4 illustrates an example of an OTP memory and contents of a part of the log portion 120 according to some embodiments. This OTP memory arrangement option can be referred to as unaligned access. The sole purpose of the unaligned access is to further reduce memory size need.

In the figure 4, 'adr' refers to address, *'PAYLOAD'* refers to a data value, '*' refers to a "packet continues bit", which may also be used as an indicator of start of log portion, and '.' refers to a start-of-CRC marker. These exemplary placeholders were chosen to make the example graph better illustrate a possible implementation: There are typically less bits in the address compared to number of bits in the data value; similarly, the acronym 'adr' is shorter than *'PAYLOAD'.* CRC or other applicable error-detecting code is typically longer than 'adr' and *'PAYLOAD',* and thus marked with a repeating pattern 'CRCRCR...'The combination of adr-PAYLOAD represents essentially an address-data value pair.

The basic idea in the unaligned access is that data boundaries do not need to match with memory block boundaries dictated by traditional memory interfaces. Instead, from system hierarchy point of view, the OTP memory merely comprises a 'row' or 'line' or 'array' of individual bits stored in individual memory cells. In this context a memory cell refers to a unit configured to store value of a single bit. The memory cell may comprise a single physical memory cell, or, when differential coding is used, two physical memory cells. Like in the aligned access scheme, bit patterns in the unaligned access preferably include error correction capabilities, such as parity bits and/or ECC.

Unaligned access can be applied both to the linear portion and to the log portion. In the linear portion, unaligned access enables omitting any unused bits, thus maximizing utilization of the OTP memory chip area in the linear portion. In the log portion, unaligned access enables relatively free choice of entry sizes that is independent of OTP memory block size. Entries may be understood as struct elements, referring to a composite data type, representing a set of data values that occupy a predefined amount of memory. The entry is preferably an address-data value pair or an error-detecting code. A union comprises one or more address-data value pairs and error-detecting code. The union is a collection of structs and is characterized by a possibility to identify the composition/signature of present struct while reading the union. The sizes of these structs may differ, and therefore the size of the union is unknown at the start of the read and known when the read completes. As a concrete example, at the beginning of the read, the reader will not know how many address-value pairs will precede the next error-detecting code, but after read has completed, the reader knows that.

For supporting unaligned access, the ASIC needs to have a proper read procedure. Unaligned access needs somewhat more complex addressing system than aligned access illustrated in connection to figures 2 and 3, but since the ASIC only needs to be able to initialize itself by unconditionally parsing the entire contents of the OTP memory until the end of write in a systematic predetermined way, many complications associated with data packing affect algorithms at factory machines only. When using unaligned access, the address is a struct that contains a data ordinal rather than a bus address. An already existing memory block can be utilized to a bus address translator and consequently, OTP memory utilization can be improved because of less bits in struct, in addition to compacting the actual data written in the OTP memory.

When discussing unaligned access, the data value, the address, ECC, error-detecting code and any other data stored in the OTP are preferably unaligned. In other words, stored data is not aligned with memory blocks, but any type of data can start at any memory cell. However, communication between the OTP reader and other functional parts of the ASIC main remain the same, regardless of whether the aligned or unaligned access is being used.

In the context of this invention disclosure, a bus is a method from transferring pieces of data from one part of system to another, usually utilizing common resources. Advanced Microcontroller Bus Architecture (AMBA) Advanced Peripheral Bus (APB) Protocol Specification by Arm Ltd is a non-limiting example of a data bus. Especially when considering unaligned access, limitations of the APB, although used as an example of data bus, are not limitations of this disclosure, i.e. the fact that APB data strobe granularity happens to be eight bits does not prohibit a different granularity to be applicable. The term bus address refers to a unique identifier, used by the bus to convey the data to its intended storage location.

### Error correction

There are several algorithms known that can be used for correcting memory read errors. These differ from each other by the number of additional bits relative to data bits, and by the types of errors that can be corrected. An example of ECC is Hamming code, without excluding other types of ECC from being compatible. The larger an ECC block is, the smaller the overhead, in other words, additional consumption of memory due to error coding, is. On the other hand, single-error-correction algorithms can only correct one error in one bit of the respective payload. If there were two erroneous bits, then the smaller the ECC block, the less likely it is that both errors appear in data associated with the same ECC block.

Usually, the ECC is added to the stored data in low level: For example, every 32 bits of payload is replaced by 40 bits, and whenever a read operation happens, 40 bits are read physically, and then replaced by 32 bits after applying the error correction algorithm. This approach hides complexity, ECC can be neglected in vast majority of discussions, but limits data values to be written into predetermined memory block size, i.e. 32 bits, with a fixed boundary between data values.

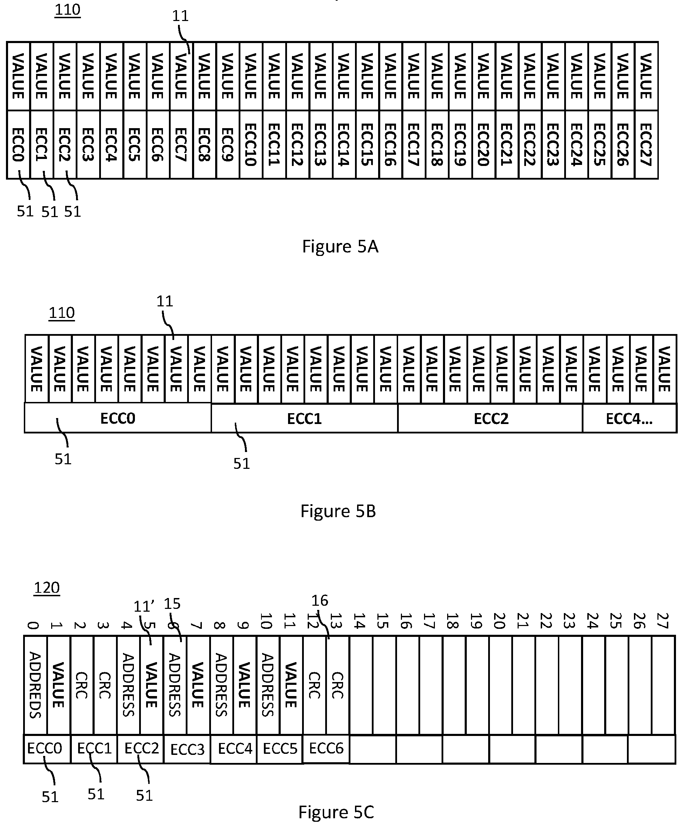

Figure 5A and 5B illustrate the concept of error correction code in the linear portion, and effect of ECC block size.

In a typical OTP memory design, ECC block size is small, as illustrated in the figure 5A. In this example, ECC blocks 51 are provided in a straightforward manner, one ECC block 51 per data value 11. This corresponds to the above-mentioned example, in which every 32 bits of payload (data values) is replaced by 40 bits, and whenever a read operation happens, 40 bits of the memory block are read physically, and then replaced by a data value with the size of 32 bits, which are stored in the working memory after applying the error correction algorithm. In some embodiments, if any bit of the 32 bits of payload is changed due to error correction algorithm, the data value may be noted as being suspicious. For example, there may be something wrong in an individual memory cell the memory block in which this data value was written. During write and/or rewrite process, noting a data value (a memory block) suspicious may trigger need to rewrite the data value in the log portion to ensure its correctness.

Figure 5B illustrates use of greater ECC blocks, each ECC block 51 being associated with a plurality of pieces of payload. In the linear portion 110, these plurality of pieces of payload are all data values 11. Number of payload data associated with a single ECC block 51 is a design option.

Bigger ECC blocks reduces ECC overhead in view of number of bits that need to be stored and thus reduces pressure for large OTP memory size, but there is also a drawback: all payload need associated to the ECC block need to be read first in registers used by the reader of the ASIC for running the ECC, before the actual payload (data values) can be stored in the working memory, which is only done after running the ECC operation. The memory designer thus makes decisions on ECC based, at least, on the OTP memory size and the desired error correction capability.

Figure 5C illustrates the concept of error correction code in the log portion 120, when log portion 120 is implemented using aligned write, which uses the predefined OTP memory block size for each piece of payload as illustrated in Figure 3.

In this non-limiting example, each ECC block 51 is associated with a two OTP memory blocks. In the exemplary log portion 120, two OTP memory blocks carry an address-data value pair or an error-detecting code 16.

In case of unaligned access, the ECC block size does not match a write size, but write blocks need to be expanded with virtual data, such as zeroes, and ECC is applied to such expanded write data. This causes a paradoxical situation known in logic as "Catch-22".

In unaligned access, ECC bits must be associated to the current write block only, since contents of "next write" are not known at the time a log entry is written. Size of the log entry needs to be known to do ECC. Size of the log entry is written into the log entry itself, and therefore contents of the log entry need to be digested at least partially before applying error correction. However, digesting data before error correcting that data increases significance of faults in digested bits.

The Catch-22 paradox can be resolved by assuming first, that size of the entry is equal to a predefined minimum, and masking bits accordingly. ECC is then applied. If the ECC passes without detecting any correctable or uncorrectable errors, and the assumption of entry size was correct, and the entry comprises data, such as an address-data value pair or an error-detecting code, reading the entry is deemed successful. If the ECC does not pass or the size of the parsed entry does not match the current size assumption, the assumed size of the entry is increased by one, and the steps of reading the entry and ECC is repeated until either reading is deemed successful, or a predefined maximum size of the entry is reached without successful reading of the entry. The predefined minimum and maximum sizes for entries are a design parameter.

If entry size is at the predefined maximum and ECC did not pass at this nor any smaller entry size tested, then reading may be restarted from the beginning, with the assumption that the entry size is equal to the predefined minimum, but this time a relaxed read round is performed. In this context, relaxed read refers to reading of entry, while allowing error correction by means of ECC. If ECC passes after correcting an error and the size of the entry appears to match its assumed size after correction was applied, such as an address-data value pair or an error-detecting code, reading of the entry is deemed to be successful. If reading is not deemed successful even after applying a correction of at least one bit using ECC, the assumed size of the entry is increased by one bit and reading and ECC is repeated until either the entry is read successfully with ECC applied, or the size of the entry reaches the predefined maximum size of the entry.

If the read was relaxed, and there is an error that cannot be corrected by the ECC, and an error flag is preferably risen. Optionally, a timeout may be applied, which causes proceeding to read the next memory block, with the assumption of present memory block has been intentionally invalidated for example because of a physically malfunctioning memory cell therein.

Any data value read from the log portion may not be written to obtained address candidate before the ECC passes. The term address candidate refers to a read address of any type, before ECC has passed. If an address bit would be flipped as a result of ECC correction, the whole read would fail. Therefore, the ASIC shall have enough local storage in the reader to accommodate the entire payload and ECC block between reading from the OTP memory and writing the read contents in the working memory. Because of this, injection of ECC in a log entry preferably allows multiple ECC blocks per write block, because an arbitrarily large ECC block size would in practice require infinite number of registers to be available for local storage during the read operation, which is usually not a desired design option.

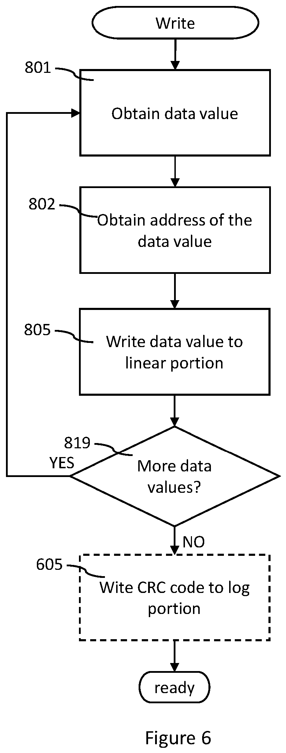

Figure 6 illustrates a simplified process of writing data in the linear portion 110. Writing can be made in a single write operation, or in multiple steps.

Before step 801, the OTP memory 100 is initially empty, no data values are stored therein. In step 801, a data value 11 is obtained. It depends on the nature of the data value 11, where it is obtained from. For example, when the first written data value comprises at least one unique identifier, and the integrated device under construction is thereafter transferred to a different step of the manufacturing process, performed with a different manufacturing apparatus, there may be a need to read the unique identification for example for purposes of storing individual log information about various steps of the process in a manufacturer database. Data values that can be directly stored in the linear portion may also comprise many initial parameter values, which have been predetermined for this type of product during its design. Such predetermined data values may be obtained from any external storage and stored in the linear portion. Many values of parameters can be predetermined with great accuracy during the design process of the integrated device and can be stored in the linear portion directly in the first write round. Any predetermined data value, such as the unique identifier, or a data value determined based on design of the integrated device may be available to the manufacturing equipment that writes data in the linear portion from a memory, or a database associated with the manufacturing equipment.

Some data values 11 may be first determined by some manufacturing equipment, such as a calibration equipment during a calibration process. An address obtained in step 802 determines, in which memory block of the linear portion 110 the data value 11 is to be written in step 805. Data values in the linear portion 110 may also be referred to as initial data values. First writing of initial data values 11 may be for example a step in a manufacturing process in which at least one unique identifier of the ASIC and/or the integrated device is written in the linear portion 110. Step 805 may take place even before the OTP memory or an ASIC comprising the OTP memory is diced from a wafer that carries a plurality of ASIC. This enables following each individual chip and/or integrated device through all later steps of the manufacturing process. If it is determined in step 819, that there are more data values to be written, the process returns to step 801, until no more data values are available that need to be stored in the linear portion. Upon completing a write round, it is possible to add a CRC to the log portion, even if all data values stored so far are in the linear portion. This enables making cyclic redundancy check for the currently stored data when it is read.

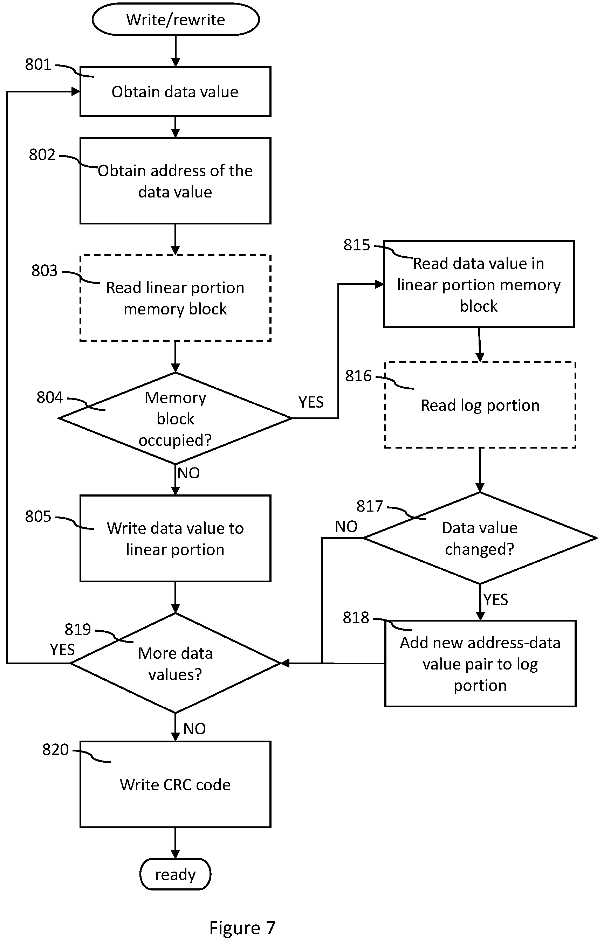

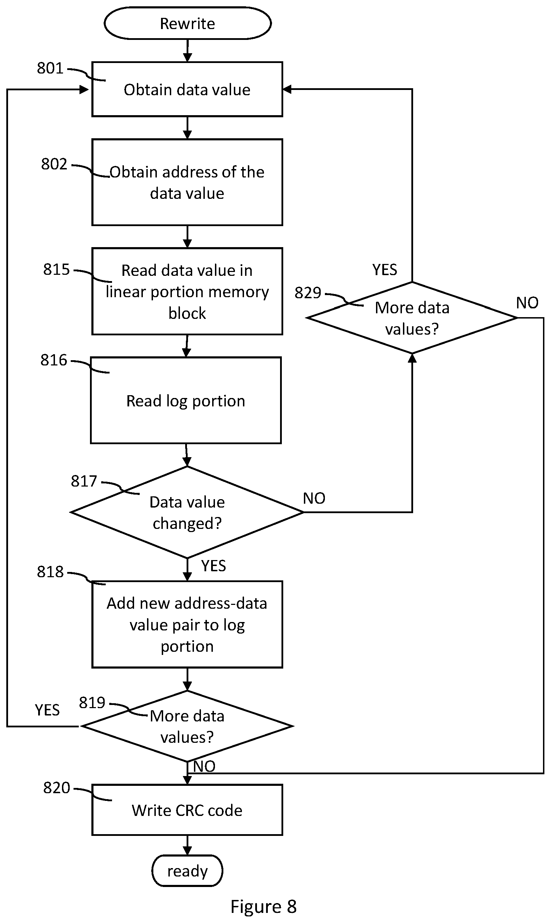

The process of writing data permanently in the linear portion 110 may comprise an optional step of reading data values previously stored therein. Examples of writing data in a process that involves reading data is illustrated in Figures 7 and 8.

Figure 7 illustrates main steps of an exemplary process for writing and/or rewriting data values according to some embodiments. This example illustrates a process that can be applied when partial write of the linear portion is applied. This leads to a situation in which some of the memory blocks in the linear portion have initial data values, but some remain empty after any earlier write round. It should be noted that while each piece of data preferably has a predetermined memory block in the linear portion, the partially written linear portion is not necessarily filled in order, but individual pieces of data are written in their respective assigned memory blocks, which may reside anywhere in the linear portion 110.

In step 801, a data value is obtained. According to some embodiments, at least some initial data values stored in the linear portion 110 are obtained by performing one or more calibration procedure for the integrated device. Thus, obtained data values may be based on measurements made using any applicable calibration equipment. In step 802, the address of the obtained data value is determined. The address determines, in which memory block in the linear portion 110 the obtained data value is associated with. The address may be initially obtained as an ordinal, in which case it is converted into a bus address. If the address of the data value may alternatively be obtained as a bus address, in which case it does not require any conversion.

If there is a possibility to have a partially written linear portion, the memory block in the linear portion 110 defined by the address obtained in step 802 is read in the step 803, and in step 804 it is determined whether there is data stored in this memory block that was read. If it is determined in step 804 that no data value was available in the read memory block, the process proceeds to step 805, in which the data value obtained in step 801 is written in the memory block determined by the respective address that was obtained in step 802. For determining whether the memory block is occupied, it is not necessary to read full contents of the memory block, but for example reading a couple or a few memory cells in the beginning of the memory block may be sufficient.

If it is determined in step 804 that the memory block is occupied and thus, there is already a data value stored in the read memory block identified by the obtained address, the data value is read from the memory block in step 815.

If there is any data stored in the log portion, contents of the entire log portion are read in step 816 for determining, whether this specific data value stored in the memory block of the linear portion has been changed during some subsequent rewrite. Reading the log portion in step 816 is needed during this process only, if there is some data in the log portion. After performing steps 815 and the optional step 816, it is known, what is the current value of this data value stored in the OTP memory. In step 817, the data value obtained in step 801 and the current value read from the linear portion or, if applicable, from the log portion, are compared to determine, whether the data value has changed since the latest write/rewrite. If the data value has changed, a new address-data value pair is stored in the log portion in step 818.

After either writing the data value in the linear portion in step 805 or writing the respective changed data value in step 818, it is determined in step 819, whether there are more data values available for processing by this write/rewrite process. If so, the process returns to step 801.

There may be more than one step in the manufacturing process that is used for writing data values in the linear portion 110. For example, the integrated device may be subjected to more than one different testing and/or calibration procedures, each designed for determining data values for at least some applied variables. Thus, the process illustrated in the figure 7 may be repeated as many times as needed, before writing of data values 11 in the linear area is complete.

After step 805, an ECC may be written in the linear portion 110. If data values are written in the linear portion 110 in more than one write rounds, an ECC may be written after each write in step 805, or according to the applied ECC scheme. Likewise, ECC may be written in the log portion after each rewrite in step 818, or after more than one rewrites.

After all data available until the end of this write/rewrite round has been written, a CRC code is preferably added in the log portion in step 820. This enables ensuring correctness of data stored in the OTP memory upon reading. The CRC code may be written in the log portion even if there are no address-data value pairs stored in the log portion. This enables performing a CRC for any data written in the linear portion when read, both after a partial write of the linear portion and after writing of the linear portion has been completed.

As the capability to read a partially programmed linear region is not needed by a working component after manufacturing has become complete, the ASIC does not have to be able to parse partial write, i.e. when only part of the linear portion is initially written into. The ASIC merely has to provide a low-level interface for factory usage that allows the manufacturing equipment to extract this information. This simplifies the design of the ASIC.

Figure 8 illustrates steps of a rewrite operation according to some embodiments, after write of the linear portion is complete, in other words after all initial data values have been stored in the linear portion, and changes in data values is possible only by writing them in the log portion.

When writing an updated data value in the log portion, it is always stored in the log portion in form of address-data value pairs.

For example, these steps may be applied when a plurality of calibration rounds are performed for the same integrated device, and some data values need to be updated based on the most recent calibration round. The plurality of calibration rounds may be performed in a variety of predetermined, mutually different ambient conditions. Depending on the type of the integrated device, other characteristics of the ambient environment may need to be varied to ensure proper calibration. For example, each calibration round may be performed in predefined, but mutually different ambient conditions in which one or more predetermined ambient conditions are selected among: temperature, pressure, offset gain, crosstalk across measurement channels, and all the latter ones as function of temperature.

In step 801, a data value to be written into the memory is obtained. The data value may be obtained for example by performing a calibration procedure while the integrated device being calibrated is under certain ambient conditions.

In step 802, the address of the obtained data value is determined. Similar to what was already discussed above, the address may initially be an ordinal, in which case it may be converted into a bus address. However, it is also possible, that the manufacturing equipment has information on bus addresses for each type of data value. In other words, the manufacturing equipment may know bus addresses that determines, in which memory block each initial data value is stored in the linear portion, in which case no conversion between ordinal and bus address is required.

In step 815, the data value is read from the linear portion memory block determined by the address obtained in step 802. Next, the entire log portion 120 is read in step 816. The log portion may or may not comprise an updated value for the initial data value that was read from the linear portion in step 815. After reading the log portion, the currently stored value of this piece of data is known.

In step 817, the currently stored value is compared to the data value obtained in step 801. If it is determined in step 817 that the data value has not changed, there is no need to write the obtained data value in the log portion, and the process may restart from step 801, or the process may proceed to step 820 if there are no more data values to be processed. However, if it is determined in step 817 that the data value has changed, a new address-data value pair is added in the log portion 120, to make the data value obtained in step 801 as the current data value.

In step 819, it is determined, whether there are mode data values available from the ongoing manufacturing process phase. If there is at least one further data value, the rewrite process is repeated, starting from step 801. If it is determined in step 819 or 829 that there are no more data values available, a CRC code is added to the log portion in step 820 unless all the requested writes were discarded in step 817, and thus no new data was written. If no new values were written in the log portion in this write round, step 820 may be omitted, because the previously written error-detecting code is still valid. After the optional step 820, the rewrite round is completed.

The CRC code is stored in the log portion 120 at the end of each update round. There may be several update rounds, and a CRC code is written after each update round has been completed. Because it is not known in advance, whether a subsequent calibration round triggers further data value updates, the CRC is written after each rewrite round in step 820. However, for most effective operation, any intermediate CRC code may be omitted when data values are read form the OTP memory 100. Intermediate CRC code refers to a CRC code that is followed by at least one further address-data value pair.

Reading data values may involve reading an ECC provided in the linear portion and making any necessary correction in the read data values based on the ECC. If data values are read also from the log portion, reading data values preferably involves reading a CRC code for enabling verifying that data values have been read correctly.

The method disclosed in connection with figures 7 and 8 are applicable for example when the integrated device under manufacturing is transferred to another piece of manufacturing and/or calibration equipment. Permanent data that is never updated, such as the unique identity of the integrated device, can be read by each manufacturing equipment that needs this data for keeping record of manufacturing steps of the individual integrated device. In such case, the data value is read from the linear portion 110 so that the manufacturing equipment can collect data from the data value update procedure and store those data values in association with the unique identifier of the integrated device, but since the unique identifier is never updated, the write/rewrite process never proceeds to a step where this data value is rewritten. Furthermore, previously stored data values, including initial data values in the linear portion and, if applicable, updated data values in the log portion read in in step 815 and in step 816 can be utilized in the subsequent calibration procedure steps, in which it is determined, whether there is need to update any one or more of the previously written data values based on another data update round.

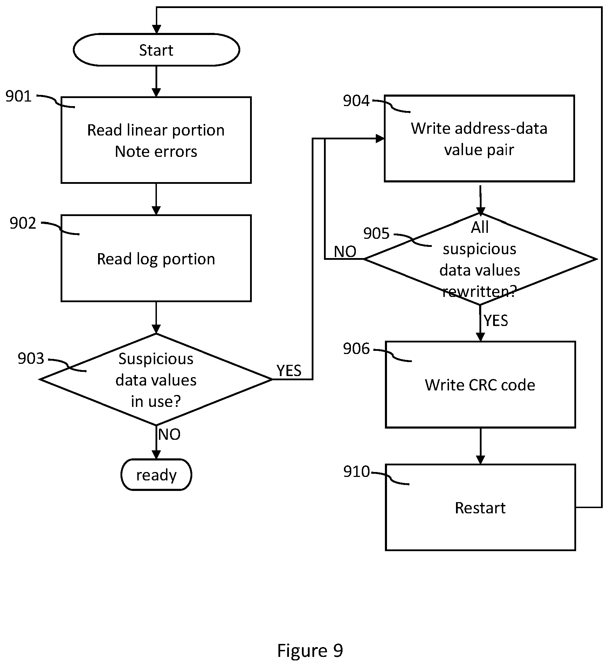

Figure 9 illustrates a rewrite process, that enables increasing yield, even if there are some weak memory blocks in the OTP memory. A weak memory block may cause a bit error in a data value, that needs to be corrected using ECC. The basic idea of this rewrite process is to use the log portion for rewriting any data values that are found suspicious based on need of applying error correction. In the context of this disclosure, suspicious refers to a memory block that is found to include corrected or uncorrected errors. In this context, a corrected error refers to an error that was identified and corrected with ECC, and uncorrected error refers to an error that was identified but could not be corrected with ECC.

The process starts from reading the entire linear portion 110 in step 901. Error coding is applied to the read data values, and any errors, whether corrected or uncorrected, are noted. Noting can also be referred to as flagging.

In step 902, the log portion 120 is read, entry by entry, and all available data values are parsed to determine, what is the current value of each data value. If a data value that was previously noted as suspicious is updated by means of a data value read from the log portion, and the data value from the log portion was not itself found suspicious, the note concerning previously noted data value is discarded - in other word the data value is un-noted (unflagged). After the entire log portion has been read, it is determined in step 903, whether there are any noted, suspicious data values left. If there was a suspicious data value left, this would mean that the integrated device would use the suspicious data value(s) in its operation. If there are no suspicious values noted, data is deemed to be read successfully, and the data reading process has been successfully performed.

However, if it is determined, that there are any suspicious data values still in use in step 903, these suspicious data values are rewritten by writing respective new address-data value pairs in the log portion in step 904, and the rewritten data value is un-noted. This data value rewriting and un-noting is repeated until it is determined in step 905 that there are no more suspicious data values. After all updated data values have been stored in the log portion in steps 904 and 905, a CRC is added to the log portion in step 906. The process then returns back to step 910, in which the entire read process is restart. If rewriting suspicious data values was successful, the read process runs through after the restart without any suspicious data values being left in step 903.

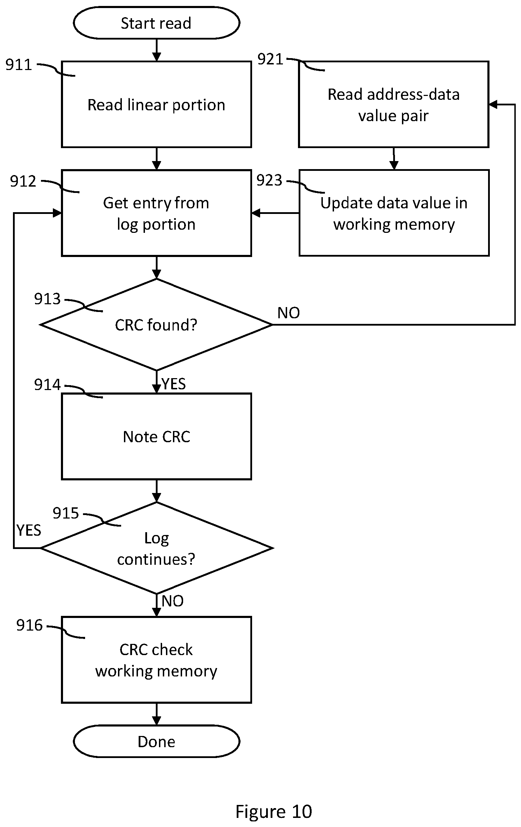

Figure 10 illustrates main steps of a process of reading of data values from the OTP memory 100 according to some embodiments. Data values are typically read from the OTP memory to the working memory upon initializing operation of the integrated device.

In step 911, data values are read from the linear portion and transferred to a working memory of the ASIC.

The read process may utilize a local storage as an intermediate step in the reading process to enable error correction of read data values using for example ECC, before data values are transferred to the working memory. Error correction is performed for read data temporarily stored in the local storage, and data is preferably transferred to the working memory only after correctness of the read data values have been verified, and error correction has been performed using the ECC, if needed. Local storage refers to a temporary storage of data in the ASIC that is used by the reader. As discussed above, there may at least one ECC in the linear portion, which may be used for verifying and, when needed, correcting a data value read from the linear portion.

The local storage in the ASIC may be for example a distributed memory or a random-access memory RAM. Distributed memory may, for example, refer to D flip-flops, latches or other suitable memory blocks, distributed over the area of the ASIC in vicinity of the area of the ASIC that uses data stored in the distributed memory. All data in the distributed memory is readable at any time, i.e. data can also be read simultaneously from a plurality of memory blocks of the distributed memory.Next, the process proceeds to parsing the log portion.

In the step 902, an entry is read from the log portion. As illustrated in figures 3 and 4, the entry is either an address-data value pair (15, 11'), or an error-detecting code 16, such as a CRC or a checksum, and each entry may further include error correcting code.

As a first step (not shown) it may be determined whether there is any data in the log portion. This can be performed by reading at least the first memory block in the log portion. If the read memory block is determined to comprise a valid address or a CRC (or any type of error-detecting code applied), it is determined that there is data available in the log portion. In practice, it is very rare that the log portion of the OTP memory of the integrated device would be totally empty, so that it is acceptable to assume that the log portion will always comprise some data.

In step 912, a first entry is obtained from the log portion. At this phase it is not known what the contents of the obtained entry are. When using aligned access, the entry may be comprised in a single memory block, or in more than one memory blocks. If unaligned access is applied, position and size of entries are not limited by memory block limits. In unaligned access, a union may be read first, comprising more than one entry, i.e. a plurality of address-data value pairs, and possibly a CRC. Entries of the union are preferably processed one by one, in which case step 912 is preceded by obtaining the union and identifying individual entries therein. Handling of unions requires the reader to have more capacity in its local storage than handling individual entries only.

In step 913 it is determined whether the obtained entry is an error-detecting code, represented herein by the exemplary CRC code. If the entry is identified as a CRC code, the CRC code is preferably noted and stored temporarily in step 914, but no CRC is performed. In step 915 it is determined whether there is data stored in the log portion after the obtained CRC code. If there is any data stored after the previously obtained CRC code, there is more data to be read from the log portion, and the process returns to step 912. Presence of data in the log portion after a CRC can be detected for example by detecting an end-of-log marking.

If it is determined in step 913 that the entry read from the log portion in step 912 is not a CRC, but an address data-value pair. Reading of the address-data value pair may be determined for example by determining, that read entity starts with a valid address. The address-data value pair is then read in step 921 and the data value is updated in the working memory in step 923. As discussed earlier, the address-data value pair is preferably first read to the local storage and error correction using ECC may be performed before the data value is transferred to the working memory. After the data value has been updated in the working memory, the process returns to step 912 for reading next entry in the log portion.

Data values determined by address-data value pairs read from the log portion are stored in the working memory, replacing respective previously stored data values with the newly read, updated data values.

If, in the step 915, it is determined that there is no more data in the log portion, but the last read CRC code was actually the final piece of data in the log portion, data values in the working memory are verified by performing a CRC (or any other applied error-detecting process) in the step 916. If the CRC is determined in the step 916 to be successful, the data values read from the OTP memory to the working memory are deemed to be successfully read and can be applied for integrated device operation.

Omitting an intermediate, noted CRC code that is read from the log portion before further address-data values are read is preferred, because this simplifies and speeds up the data reading process. Processing the intermediate CRC code at this phase is unnecessary, since any later stored updated data values in the log portion may replace previous, possibly erroneous data values, and thus a failed CRC during an ongoing log portion read using an intermediate CRC code could unnecessarily indicate an error.

The read process may also be illustrated with a simple pseudo code:

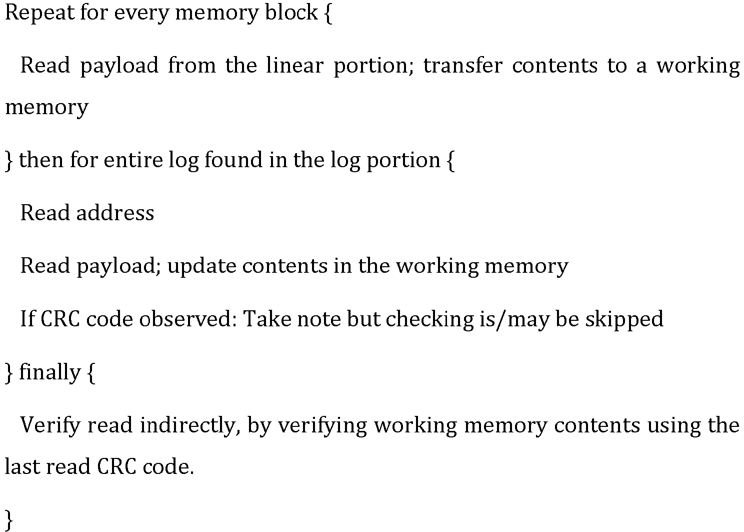

According to the preferred embodiment of the invention, intermediate CRC codes are not used for error-detection at all, but only the last CRC code is used to check that the final data values stored in the working memory are correct, only after reading all data stored in the log portion. It is more important to know that the final data values have been correctly obtained and transferred to the working memory, whereas intermediate stages are of less interest. This facilitates simplification of the reading process: leave out everything that is not needed. Technically, the CRC may be checked using the same circuitry that checks working memory validity during normal operation of the integrated device. Leaving out anything that is not necessary facilitates smaller size of the OTP memory and thus also the ASIC itself, which cuts costs.

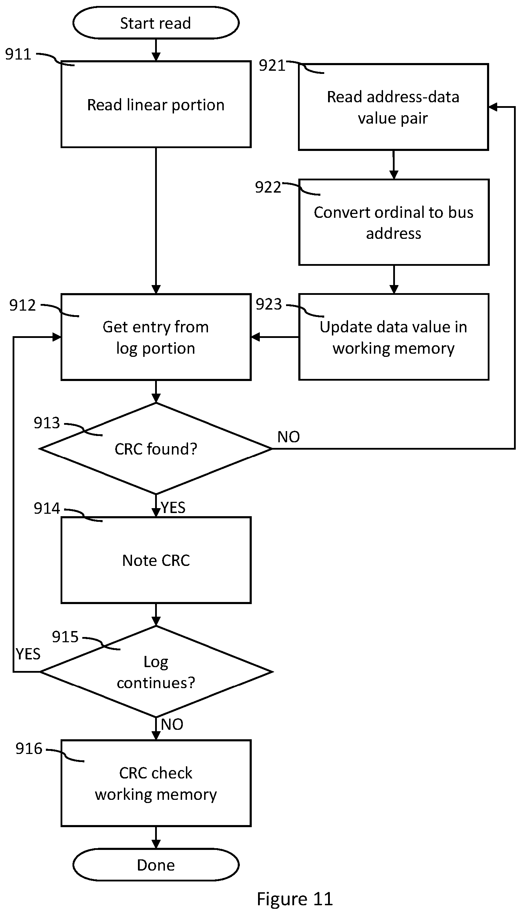

Figure 11 illustrates main steps of a process of reading of data values from the OTP memory 100 according to some embodiments.

In the process shown in the figure 11 is already discussed in connection with figure 10. In addition, Figure 11 shows in more detail step for handling addresses. The address read in the address-data value pair of the log portion in step 921 may be an ordinal, which is first converted to a bus address in step 922, before the data value can be updated in the working memory in step 923. The reader in the ASIC may comprise a hardcoded ordinal-to-bus-address converter for performing the ordinal-to-bus address conversion. Other steps in the figure 11 correspond to those described in connection with figure 10.

At first sight, the data reading process according to figures 10 and 11 may appear problematic since, if any initial data values stored in the linear portion, and possible intermediate data values from the log portion, are later changed into final, correct values read from the log portion, the working memory will briefly have some "wrong" or outdated data values stored therein. However, in an integrated device such as a MEMS device, this is not a problem, because readout of the OTP memory is performed as a part of a power-on or a reset procedure, where brief non-perfect operation may be acceptable from the point of view of the end user. The working memory can be implemented as any known type of volatile on-chip memory.

Any initial data values are typically good approximations of the final, updated data values. Typically, data values can be estimated in advance with relatively high accuracy, even though some values need to be updated for example during the calibration process. It is common, that most predetermined data values that are initially stored in the linear portion do not need to be updated, but only a small fraction of data values are updated during calibration. Data values that need to be changed during calibration typically improve operation accuracy of the integrated device, such as measurement accuracy of a sensor device, but decent accuracy may be achieved with the initial data values.

Amount of data in the log portion affects the total time needed for reading all correct data values into the working memory. If the log portion is short, updated data values are quickly read, but if the log portion is almost full, it takes some more time to read and update all data with correct, updated data values in the working memory. However, initiation of operation of an integrated device takes some time, and often other steps in the integrated device initiation process take so much time, that the integrated device is not operational in any case before all updated data values have also been read from the log portion.

There is a need to detect, when all data in the log portion has been read, i.e. when an end of content in the log portion was reached. Since the log portion is also part of the OTP memory, such marking of end of log should be implemented in a manner that it can be later converted into a new log entry.

### End of log marking

When unipolar coding is used, one memory cell determines value of one bit. If all memory cells of an unprogrammed OTP memory block are read as a zero, a straightforward way to find end of the log by determining that a register value zero, that is read as an "address" is determined as unused, so that when the reading process arrives to an OTP memory block with all zeros, this indicates end of log. Log continuation may also be indicated using some other means, such as a dedicated parsing hint bit. If all memory cells of an unprogrammed OTP memory block are read as one, then the invalid address and polarity of other optional token bits should be matched accordingly.

Memory cells of the OTP memory blocks may also apply differential coding, in which two physical memory cells are used for coding the value of a single bit. For example, a "01" may represent one and "10" may represent a zero. When data values are written in differential way, one of the two memory cells is processed accordingly, and upon reading, data value of the bit may be determined by comparing resistances read from the two memory cells. Differential coding is a known method for making a memory more robust against small deviations of electrical characteristics of individual memory cells.

The term memory cell as used herein refers to a memory unit that is configured to store a value of a single bit. Thus, the term memory cell may refer to a single physical memory cell or to a two physical memory cells that are used for differentially coding value of a single bit.

When differential coding is applied, at least one physical memory cell pair represent a value of a single bit. For example, one or two physical memory cell pairs may be used to represent a single bit. In such case, a robust solution to detect end of data in the log portion is to read start of a new OTP memory cell first exceptionally in unipolar mode, after detecting end of updated data based for example on detecting a CRC code in the differential mode. Reading only two physical memory cells may be sufficient to determine whether there is further data in the log portion. If these two first memory cells read in the unipolar mode have equal value, there is no further data in the log portion, but if the two first memory cells have mutually different values, it may be determined that there is more data in the log portion that need to be read and processed. After presence of further data has been determined using the unipolar reading mode, reading of data from these memory cells is then performed in differential mode.

Alternatively, more than two physical memory cells may be used for detecting end of data in the log portion. If a significant majority of the more than two physical memory cells after suspected end of log are determined to be unprogrammed, it can be determined that the log did end. If approximately half of the bits appear to be programmed, the log continues. Such simple discrimination between programmed and unprogrammed memory cells allows a robust detection of end of log even in circumstances where unipolar reading has a small change of misinterpreting memory cell values. A physical memory cell is unprogrammed, if the initial value thereof has not been flipped by programming.

### Error correction

Error correction code, ECC is a commonly known method to allow correction of bit read failures and may also enable detecting some other errors.

Efficiency of the disclosed method of OTP memory use is also affected by number of bits reserved for error correction capabilities using error correction code, ECC. For example, some known ASIC OTP memories use a 32/40-bit coding scheme, in which 40 bits are used to carry 32 bits of data, while the remaining 8 bits are reserved for ECC purposes. This exemplary arrangement allows correction of single bit read failures. For improving error detection, the error coding scheme may be adjusted for example by adding more ECC bits, but this reduces overall efficiency of OTP memory usage in terms of amount of data that can be stored therein. Preferably, actual read error density of the OTP memory is determined before corrections, an accepted read error density can be determined after ECC corrections, and amount of ECC bits is determined based on these factors.

Optimization of ECC code is outside the scope of this disclosure, but it should be noted that if an uncorrected error is observed in any data value during the manufacturing process, it is possible to rewrite contents of the entire data value with its ECC bits in the log portion. Error checking can be performed after all data has been read from the log portion, and thus the initial error becomes obsolete. This is a benefit over the solution disclosed in US 11,854,588 B2, because number of bits that cannot be corrected, such as pointer corruptions in that prior art solution are fatal.

### Writing

One characteristic of the disclosed OTP memory solution is that the ASIC circuit itself only needs to be able to read contents of the OTP memory. There is some algorithmic complexity in the OTP memory readout process, but this has little if any price in terms of chip area. However, since all data is written in the OTP memory during the manufacturing and/or calibration process, using dedicated manufacturing and/or calibration equipment, the entire ASIC can be implemented without any write-operation functionality, which enables reducing the total chip area.

### Partial first write

Implementing read-only capabilities in the ASIC is also feasible design when data values are written in the linear portion of the OTP memory in more than one writes. Even though there may be large ECC blocks, some bits of the OTP memory space can be reserved for "factory use only", for example for storing a checksum(s) for the unique identifier(s). Such additional checksums may be reserved for production line use only, and the ASIC only needs to know that these checksums are to be skipped during OTP memory readout. Preferably, after first calibration all ECC and logs are intact from the ASIC point of view.

## Claims

1. A one-time programmable, OTP, memory configured to provide functionalities of a multiple-time programmable, MTP, memory, the OTP memory comprising
- a linear portion configured to store a plurality of initial data values, and
- a log portion configured to store at least one address-data value pair, wherein each address-data value pair represents an updated data value of one of the plurality of initial data values that has been stored at a position of the linear portion determined by the address.

2. The OTP memory according to claim 1, wherein the log portion further comprises at least one error-detecting code, such as a cyclic redundancy check, CRC, code, stored after one or more address-data value pairs.

3. The OTP memory according to any one of claims 1 or 2, applying aligned access, wherein boundaries of initial data values, address-data value pairs and error-detecting code align with boundaries of OTP memory blocks, or applying unaligned access, wherein boundaries of initial data values, address-data value pairs and error-detecting code are not necessarily aligned with boundaries of OTP memory blocks.

4. An integrated device comprising a functional portion and an application-specific integrated circuit, ASIC, comprising the OTP memory according to any one of claims 1 to 3, wherein the OTP memory comprises data values for operating the integrated device.

5. A microelectromechanical system, MEMS, device comprising a MEMS portion and an application-specific integrated circuit, ASIC, comprising the OTP memory according to any one of claims 1 to 3, wherein the OTP memory comprises data values for operating the MEMS device.

6. A method for writing data values in a one-time programmable, OTP, memory, the OTP memory comprising a linear portion configured to store a plurality of initial data values, and a log portion configured to store updated data values, the method comprising:
- obtaining one or more data values, and for each data value:
∘ obtaining an address of the data value, wherein the address indicates a position in the linear portion;
∘ reading an initial data value from the position of the linear portion indicated by the address, and using the initial data value as a current data value;
∘ if the log portion comprises data, reading the entire log portion to determine, whether the log portion comprises one or more address-data value pairs indicating updated data values for the respective initial data value in the linear portion, the address referring to the position of the respective initial data value, and using the respective data value read from the last respective address-data value pair as the current data value;
∘ comparing the obtained data value with the current data value; and
∘ if the obtained data value is different than the current data value, writing a new address-data value in the log portion, wherein the address is the obtained address indicating position of the respective initial data value in the linear portion and the data value is the obtained data value;
- after all obtained data values have been processed, adding an error-detecting code to the log portion.

7. The method according to claim 6, wherein the write operation further comprises:
- if, upon trying to read the initial data value from the linear portion, it is detected that the position in the linear portion indicated by the obtained address does not have any initial data value stored therein; and
- storing the obtained data value to the position of the linear portion indicated by the obtained address; and
- after storing the obtained data value in the linear portion, proceeding to obtaining another data value, if available.

8. The method according to claim 6 or 7, wherein the OTP memory is comprised in an ASIC of an integrated device, and the integrated device further comprises a functional portion, and the OTP memory is used for storing data values for operating the integrated device, wherein the method comprises:
- performing a calibration of the integrated device,
- obtaining one or more data values based on the calibration, and
- writing said one or more data values into the OTP memory.

9. The method according to any one of claims 6 to 8, further comprising:
- reading all data values stored linear portion, and applying error correction therein;
- if a corrected or uncorrectable error is detected in a data value read from the linear portion, marking respective data value as suspicious;
- reading all address-data value pairs stored in the log portion, and, when available, replacing data values read from the linear portion with data values read from the log portion, and
∘ if a corrected or uncorrectable error is detected in a data value read from the log portion, marking respective data value as suspicious, and
∘ if a data value is read correctly from the log portion, replacing the data value previously marked as suspicious, removing the marking from the data value as suspicious,
- after all data values have been read, checking whether any data values marked as suspicious remain, and if so,
∘ rewriting address-data value pairs in the log portion, for replacing all remaining data values marked as suspicious,
∘ after all data values that were previously marked as suspicious have been rewritten in in the log portion as address-data value pairs, writing an error-detecting code in the log portion.

10. A method for reading data values stored in a one-time programmable, OTP, memory, the OTP memory comprising a linear portion and a log portion, the method comprising:
i) reading initial data values from the linear portion, and storing the initial data values in a working memory,
ii) obtaining an entry from the log portion,
iii) determining whether the entry indicates presence of an error-detecting code or an address-data value pair,
iv) if the entry indicates presence of an address-data value pair, reading the address-data value pair, the address referring to the position of the respective initial data value, and the data value replacing the respective initial data value and any previously stored updated data value of the respective initial data value in the working memory, and
v) if the entry is an error-detecting code, noting the error-detecting code,
vi) repeating steps ii) to v) until it is determined that there is no further entry in the log portion, and
vii) upon determining that there is no further entry in the log portion, performing an error detection using the last read error-detecting code.

11. The method according to claim 10, wherein presence of an address-data value pair is determined by detecting that the read entry comprises a valid address.

12. The method according to claim 10 or 11, wherein differential coding is applied, and wherein step vi) comprises reading at least one physical memory cell pair after the previously read entry in unipolar mode, and based on the reading of the at least one physical memory cell pair:
- determining that there is no further entry in the log portion based on detecting that all or a significant majority of the physical memory cells in the at least one physical memory cell pair read in unipolar mode are unprogrammed, and/or
- determining that the log portion comprises further entries based on detecting that approximately half of the physical memory cells in the at least one physical memory cell pair read in unipolar more appear to be programmed.

13. The method according to any one of claims 6 to 12, applying aligned access, wherein boundaries of initial data values, address-data value pairs and error-detecting code are aligned with boundaries of OTP memory blocks.

14. The method according to any one of claims 6 to 12, applying unaligned access, wherein boundaries of initial data values, address-data value pairs and error-detecting code are not always aligned with boundaries of OTP memory blocks.

15. The method according to claim 14, wherein, when reading data from the log portion comprises:
- assuming that the size of the entry is equal to a predefined minimum, and
a) reading an entry from the log portion, and
i. applying error correction on the entry, and if the error correction passes without need to correct any errors and the size of the entry matches the assumed size of the entry, determining that reading of the entry was successful, and
- if reading of the entry in step i. is not determined to be successful, increasing the size of the entry by one and repeating step a) until either i. is determined to be successful, or until the size of the entry reaches a predefined maximum, and
- if the size of the entry reaches the predefined maximum without the reading of the entry being successful, assuming that the size of the entry is equal to the predefined minimum, and proceeding to
b) reading the entry from the log portion, and
ii. applying error correction on the entry, and if the error correction is performed successfully, and size of the entry matches the assumed size of the entry after the error correction was applied, determining that reading of the entry was successful,
- if reading of the entry in step ii. is not determined to be successful, increasing the size of the entry by one and repeating step b) until ii. is determined to be successful, or until the size of the entry reaches a predefined maximum, and
- if the size of the entry reaches the predefined maximum, and reading of the entry was not determined to be successful, deeming reading of the entry failed and optionally rising an error flag.
